# EUROPEAN PATENT SPECIFICATION

(11) **EP 4 330 770 B1**
(45) Date of publication and mention of the grant of the patent: **04.03.2026**
(21) Application number: 22722502.6
(22) Date of filing: 12.04.2022
(51) Int. Cl.: G03F 7/00, G03F 9/00, B29D 11/00, G02B 5/18

(54) **MULTI-LEVEL STRUCTURE FABRICATION**
HERSTELLUNG EINER MEHRLAGENSTRUKTUR
FABRICATION DE STRUCTURE MULTINIVEAU

(30) Priority: 26.04.2021 US 202163179741 P
(43) Date of publication of application: 06.03.2024
(73) Proprietor: NILT Switzerland GmbH, 8810 Horgen (CH)
(72) Inventor: ZALKOVSKIJ, Maksim, 2800 Kongens Lyngby (DK)
(74) Representative: Fish & Richardson P.C.
(86) International application number: PCT/EP2022/059788
(87) International publication number: WO 2022/228892

(56) References cited:
- WO-A1-2020/185954
- US-A1- 2016 099 380
- US-A1- 2016 365 276
- US-A1- 2017 068 025
- US-A1- 2021 082 697

## Description

### FIELD OF THE DISCLOSURE

The present disclosure relates to the fabrication of optical and other structures.

### BACKGROUND

In a replication process, a given structure or a negative thereof is reproduced. In some cases, a structure is reproduced in a replication material disposed on a substrate. Structures created by replication may serve various functions, including structures that act as optical elements such as a lens, lens array, beam splitter, diffuser, polarizer, bandpass filter, or other optical element.

WO 2020/185954 describes waveguides including materials with refractive index greater than or equal to 1.8 and methods of patterning waveguides.

US 2021/082697 describes patterning of semiconductor integrated circuit features using lithography processes incorporating a sequential infiltration synthesis technique.

US 2017/068025 describes a sensor device including one or more optical filters, such as metal-dielectric optical filters.

US 2016/099380 describes an epitaxial structure including an epitaxial substrate, a first buffer layer, a first patterned mask layer, a second buffer layer, and a second pattern mask layer.

US 2016/365276 describes methods for fabricating interconnect structures for semiconductor devices.

### SUMMARY

The invention is defined in the appended claims. In some aspects, the present disclosure describes methods. In one aspect, the disclosure describes a method including providing a substrate having a multi-layer structure disposed thereon. The multi-layer structure includes a plurality of meta-layers, each meta-layer including a hard mask layer including a hard mask material, and a spacer layer on which the hard mask layer is disposed, the spacer layer including a spacer material. A replication material is disposed on a surface of the multi-layer structure. The method includes imprinting, into the replication material, a replication pattern including a first replication feature and a second replication feature. The first replication feature and the second replication feature have different heights. The method includes performing a plurality of etching processes on the replication material, the multi-layer structure, and the substrate, to obtain a substrate pattern including a first substrate feature and a second substrate feature. The first substrate feature is aligned with a position of the first replication feature and the second substrate feature is aligned with a position of the second replication feature, and the first substrate feature and the second substrate feature have different heights.

Implementations of this or other methods may include one or more of the following features. A height of the first replication feature is smaller than a height of the multi-layer structure. The plurality of etching processes include a second etching process, performed after the first etching process, the second etching process including: etching away a portion of a hard mask layer of a first meta-layer, the etched-away portion of the hard mask layer aligned with the position of the first replication feature; and etching away a portion of a spacer layer of the first meta-layer, the etched-away portion of the spacer layer aligned with the position of the first replication feature and with a position of the etched-away portion of the hard mask layer of the first meta-layer. The second etching process causes a portion of the multi-layer structure aligned with the position of the first replication feature to include fewer meta-layers than a portion of the multi-layer structure aligned with the position of the second replication feature. The second etching process causes a portion of the multi-layer structure aligned with the position of the first replication feature to be thinner than a portion of the multi-layer structure aligned with the position of the second replication feature.

Implementations of this or other methods may include one or more of the following features. A first part of the plurality of etching processes causes the multi-layer structure to include a first portion and a second portion, the first portion thinner than the second portion. A second part of the plurality of etching processes includes etching the substrate to form a first intermediate substrate feature and a second intermediate substrate feature. The first intermediate substrate feature is aligned with the position of the first portion of the multi-layer structure and the second intermediate substrate feature is aligned with the position of the second portion of the multi-layer structure. The method includes, subsequent to etching the substrate to form the first and second intermediate substrate features: etching away the first portion of the multi-layer structure to expose the first intermediate substrate feature and to leave in place at least some of the second portion of the multi-layer structure; and etching away a portion of the first intermediate substrate feature, the second intermediate substrate feature being protected from etching by the second portion of the multi-layer structure. The method includes, subsequent to etching away the portion of the first intermediate substrate feature: etching away at least some of the second portion of the multi-layer structure; and etching the substrate to form the first substrate feature and the second substrate feature.

Implementations of this or other methods may include one or more of the following features. The method includes, subsequent to imprinting the replication pattern, etching away a residual layer of the replication material remaining on the surface of the multi-layer structure. The hard mask material is a metal or a metal oxide. The hard mask material includes chromium. The spacer material includes at least one of a photoresist, an oxide, or a nitride. The replication material includes at least one of a polymer, an epoxy, or a resin. The plurality of etching processes include a first etch that selectively etches the replication material compared to the hard mask material; a second etch that selectively etches the hard mask material compared to the spacer material; and a third etch that selectively etches the spacer material compared to the hard mask material. The plurality of etching processes include a first etch that selectively etches the substrate compared to the spacer material.

Implementations of this or other methods may include one or more of the following features. For example, in some instances, a number of the plurality of meta-layers equals or is greater than a number of substrate features formed by the plurality of etching processes, including the first substrate feature and the second substrate feature. In some implementations, the first replication feature adjoins the second replication feature, and the first substrate feature adjoins the second substrate feature. In some implementations, the first substrate feature and the second substrate feature together form some or all of an optical metastructure. In some cases, the first substrate feature and the second substrate feature together form some or all of a structure including a diffractive optical element (DOE), The substrate can have, for example, a refractive index of greater than 2.5 for at least one of ultraviolet light, visible light, or infrared light. Imprinting the replication pattern includes curing the replication material.

The disclosure also describes apparatuses. For example, the disclosure describes an apparatus including a substrate and a multi-layer structure disposed on the substrate. The multi-layer structure includes a plurality of meta-layers, each meta-layer including a hard mask layer including a metal or a metal oxide, and a spacer layer on which the hard mask layer is disposed, the spacer layer including at least one of a photoresist, an oxide, or a nitride.

Implementations of this or other apparatuses may include one or more of the following features. A replication material is disposed on the multi-layer structure. The replication material includes at least one of a polymer, an epoxy, or a resin. Each hard mask layer has a thickness between 10 nm and 50 nm. Each spacer layer has a thickness between 5 nm and 50 nm. Each hard mask layer includes chromium. The substrate has a refractive index of between 3.5 and 5.0 for at least one of infrared light, ultraviolet light, or visible light. The substrate includes a layer of a first material disposed on a second substrate comprising a second material.

Some embodiments of the subject matter described in this specification can be implemented to realize one or more of at least the following advantages. In some implementations, a pattern defined by imprinting can be transferred to a different material. In some implementations, a multi-level structure having a high refractive index can provide improved optical functionality. In some implementations, a given multi-level structure can be used flexibly to fabricate many different structures based on a low-cost, rapid imprinting process. In some implementations, faster and/or lower-cost etches can be used to produce multi-level structures. In some implementations, multi-level structures with arbitrary height differences can be produced.

The details of one or more implementations are set forth in the accompanying drawings and the description below. Other aspects, features and advantages will be apparent from the description and drawings, and from the claims.

### BRIEF DESCRIPTION OF THE DRAWINGS

FIGS. 1A-1P are schematics showing an example of a fabrication process.
FIGS. 2A-2N are schematics showing an example of a fabrication process.
FIG. 3 is a set of schematics showing an example of a fabrication process.
FIGS. 4A-4B are side and top views of an example multi-level structure.
FIGS. 5A-5B are side and top views of an example multi-level structure.
FIGS. 6A-6B are side and top views of an example multi-level structure.
FIG. 7 is a flowchart showing an example process.

### DETAILED DESCRIPTION

The present disclosure describes replication processes and devices. In certain implementations, this disclosure describes replication and etching processes to form multi-level structures in substrates.

Optical structures, which may include for example metalenses or diffractive optical elements, may be fabricated using a variety of methods. In some cases, the structure can be transferred, for example, to a curable resin by replication techniques.

In general, replication refers to a technique by means of which a given structure is reproduced, e.g., embossing or molding. In an example of a replication process, a structured surface is embossed into a liquid or plastically deformable material (a "replication material"), then the material is hardened, e.g., by curing using ultraviolet (UV) radiation or heating, and then the structured surface is removed. Thus, a negative of the structured surface (a replica) is obtained.

The replicated structure provides a mechanical, electrical, or optical functionality (or a combination of those functionalities) due to the structure imposed by the structured surface.

In some cases, replication may be implemented by stamping processes. In the case of a stamping process, which also may be referred to as an imprinting process, the structured surface is a surface of a stamp that is pressed into the liquid or plastically deformable material (or has the liquid or plastically deformable material pressed into it).

"Imprinting" or "replication," as used in this disclosure, may include other processes such as one or more of embossing, debossing, stamping, or nano-imprinting.

While in some implementations the liquid or plastically deformable material in a replication process is a bulk material (for example, a block of material), in other implementations the liquid or plastically deformable material is a layer or droplet (e.g., a coating) provided on a substrate surface.

While replication processes provide the possibility of low-cost and high-throughput, in some cases replication is less useful for forming high refractive index structures. Most (though not all) replication materials have low refractive indexes (e.g., refractive indexes less than 2.0). By contract, some materials unsuitable for direct imprinting have significantly higher refractive indexes. For example, silicon has refractive indexes greater than 3.5 for visible light, but cannot be imprinted under typical conditions.

In some cases, an imprinted replication material mask can be used directly as a mask for subsequent etching of a high refractive index material. However, some replication materials have relatively low etch selectivities compared to high refractive index materials, such that height variation in resulting multi-level structures in the high refractive index material is limited by height differences of features in replication material imprint patterns. Also, etching in such cases may be highly isotropic/lateral, leading to poor pattern transfer from the replication material to the high refractive index material.

High refractive index materials may be beneficial in optical devices. For example, the high refractive index may increase a strength of interactions between the optical device and light incident on, or generated by, the optical device, which may allow for stronger light redirection, detection, filtering, or other optical function performed by the optical device.

In accordance with implementations of this disclosure, multi-level structures are fabricated in high refractive index materials based on an imprinted pattern in a replication material.

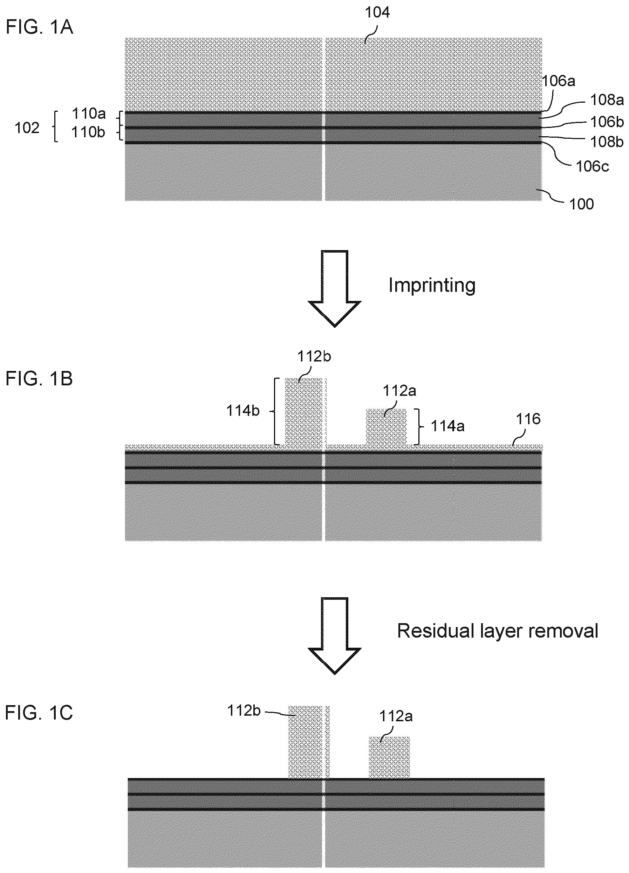

FIG. 1A shows an example starting structure usable for multi-level structure fabrication. A replication material 104 is disposed on top of a multi-layer structure 102, which is itself disposed on a substrate 100.

The substrate 100, according to some implementations of this disclosure, is a high refractive index material. The substrate 100 may be, for example, a semiconductor substrate, e.g., silicon, gallium arsenide, germanium, or zinc selenide. In some implementations, the substrate 100 is an insulating substrate, e.g., diamond or an oxide (e.g., sapphire, a titanium oxide, or a silicon oxide). As noted above, many of these materials cannot be directly imprinted under typical conditions to form multi-level structures.

In some implementations, the substrate is an overall substrate that includes a layer of high refractive index material disposed on a first substrate of different material, the layer having the described multi-layer structure disposed on top of it. The substrate features may then be formed out of either or both of the layer of high refractive index material and the first substrate. For example, a top portion of a substrate feature may be the high refractive index material, and a bottom portion of the substrate feature may be the first substrate. In some implementations, the substrate features are formed entirely out of the layer of high refractive index material disposed on the first substrate.

In some implementations, the high refractive index material has a refractive index for visible light, ultraviolet light, and/or infrared light of at least 2.0, at least 2.5, at least 3.0, at least 3.5, or another value. The refractive index may be less than 4.0, less than 4.5, less than 5.0, or another value.

In some implementations, the replication material has a refractive index for visible light, ultraviolet light, and/or infrared light that is less than the refractive index of the substrate. In some implementations, the refractive index of the replication material may be less than 2.0, less than 2.5, less than 3.0, or another value.

The multi-layer structure 102 includes at least two types of layers. A first type of layer is a "hard mask layer." In the example of FIG. 1A, layers 106a, 106b, and 106c are hard mask layers. A second type of layer is a "spacer layer." In the example of FIG. 1A, layers 108a and 108b are spacer layers.

Hard mask layers are composed of one or more hard mask materials, and spacer layers are composed of one or more spacer materials. These materials can vary depending on the implementation, for example, depending on a type of replication material to be used, a type of substrate to be used, or types of etches to be used.

In some implementations, the replication material, the hard mask material, the spacer material, and the substrate can be defined in terms of relative etch selectivities. The selectivity of an etch refers to a ratio of depth etched per unit time in one material compared to another material; the etch is said to be "selective" for the material that is etched more, compared to the material that is etched less. For example, if a certain etch process (e.g., immersion in an etch solution at a given temperature) etches silicon at 100 nm/second, and the etch process has a selectivity of 2:1 in silicon compared to in silicon dioxide, then the same etch process etches silicon dioxide at 50 nm/second.

Selective etches, according to this disclosure, may have selectivities of at least 1.5:1, at least 2:1, at least 3:1, at least 5:1, at least 10:1, at least 50:1, at least 100:1, or another ratio. In some cases, an etch is entirely selective, e.g., etches a first material while essentially not etching a second material at all.

Under this formulation, a first etch type may selectively etch the hard mask material compared to the spacer material, the replication material, and/or the substrate. A second etch type may selectively etch the spacer material compared to the hard mask material, the replication material, and/or the substrate. A third etch type may selectively etch the replication material compared to the hard mask material, the spacer material, and/or the substrate. A fourth etch type may selectively etch the substrate compared to the hard mask material, the spacer material, and/or the replication material. This configuration of layer types and etch types can allow for selective layer-by-layer etching of the various layers of the starting structure showing in FIG. 1A.

However, each etch type not need be selective for one material compared to all other materials involved. Rather, while a first layer is being etched by an etch process, a second layer, etched less or not at all by the etch process, may mask a third layer that would be etched by the etch process, were it not for the presence of the masking second layer.

In some implementations, the hard mask material includes a metal. For example, the hard mask material may include chromium, aluminum, nickel, platinum, and/or another metal. In some implementations, the hard mask material includes a dielectric such as a metal oxide, e.g., aluminum oxide, titanium dioxide, hafnium oxide, and/or another dielectric.

In some implementations, each hard mask layer has a thickness between 10 nm and 50 nm, e.g., between 15 nm and 30 nm. Other thicknesses can also be used.

In some implementations, the spacer material includes one or more of a photoresist, an oxide, or a nitride. For example, the spacer material may include silicon dioxide, silicon nitride, aluminum oxide, and/or another material.

In some implementations, each spacer layer has a thickness between 5 nm and 100 nm, e.g., between 5 nm and 50 nm or between 10 nm and 35 nm. Other thicknesses can also be used.

The replication material 104 is a material capable of being patterned by a replication process. For example, the replication material 104 may include one or more of a polymer, a spin-on-glass, or any other material that may be structured in a replication process. Suitable materials for replication include, for example, hardenable (e.g., curable) polymer materials or other materials which are transformable in a hardening or solidification step (e.g., a curing step) from a liquid or plastically deformable state into a solid state. For example, in some implementations the replication material 104 is a UV-curable, microwave-curable, and/or thermally-curable epoxy or resin (e.g., a photoresist). In some implementations, the replication material 104 is transparent to visible and/or infrared light before and/or after curing.

Replication material may be provided on the multi-layer structure 102 using one or more of printing (e.g., inkjet printing), jetting, dispensing, screen printing, dip coating, or spin coating, or by another method. In some implementations, replication material is provided on a stamp and is then brought into contact with the multi-layer structure 102 as the stamp imprints the replication material.

The multi-layer structure 102 can be thought of as including multiple meta-layers 110a, 110b. Meta-layer 110a includes hard mask layer 106a and spacer layer 108a, whereas meta-layer 110b includes hard mask layer 106b and spacer layer 108b. A final hard mask layer 106c, not included in the meta-layers 110a, 110b, is on the substrate 100.

Note that the meta-layers also could be defined differently. For example, an equivalent description of the multi-layer structure 102 would be that a first meta-layer includes spacer layer 108a and hard mask layer 106b, a second meta-layer includes spacer layer 108b and hard mask layer 106c, and hard mask layer 106a underlies the replication material 104.

In some implementations, a number of meta-layers in the multi-layer structure 102 corresponds to a number of different heights for substrate features patterned using the multi-layer structure. For example, in the example of FIG. 1A, two meta-layers are present, which, as described in more detail below, allows for the fabrication of substrate features with two different heights. However, in some implementations, given N meta-layers, a number of different heights for resulting substrate features may be less than N, depending on the fabrication process.

FIGS. 1B-1P illustrate an example fabrication process to produce a multi-level structure in the substrate 100 based on an imprinted pattern.

As shown in FIG. 1B, the replication material 104 is imprinted to form two replication features 112a, 112b. The two replication features 112a, 112b have different heights 114a, 114b, the different heights being defined by a geometry of a stamp, mold, or other structured surface used to imprint the replication material. In some implementations, a residual layer 116 of replication material (e.g., a residual layer 116 having a thickness between 10 nm and 100 nm) also remains in place, having not been completely removed by the imprinting. In this example, replication feature 112b is taller than replication feature 112a.

In some implementations, each height 114a, 114b is at least 100 nm, at least 200 nm, or another height. The each height 114a, 114b may be less than 1000 nm, less than 5000 nm, or another height. In some implementations, a difference between a height of a first replication feature and a second replication feature is between 50 nm and 200 nm.

Lateral dimensions of the replication features 112a, 112b may be, in some implementations, between 50 nm and 5000 nm, between 100 nm and 2000 nm, or another value.

The stamp or other structured surface (not shown) may be composed of a variety of materials, including a cured replication material and/or a patterned semiconductor wafer (e.g., a patterned silicon wafer), in some implementations including deposited metal layers. In some implementations, all or part of the stamp or other structured surface is transparent, e.g., is composed of glass. In some implementations, the stamp or other structured surface is thin and/or flexible, e.g., composed of polycarbonate foil. In some implementations, structured features of the stamp or other structured surface (such as a structured stamp surface having a structure corresponding to the imprinted replication features 112a, 112b) are composed of a polymer, e.g., PDMS.

In some implementations, the replication material 104 is cured during or after imprinting. For example, the replication material 104 may be cured while the stamp or other structured surface is in contact with the replication material 104, and/or the replication material 104 may be cured after the stamp or other structured surface has performed the imprinting and formed the replication features 112a, 112b. The curing may include a thermal cure, a UV cure, or both, or another curing method.

The curing may harden the replication features 112a, 112b, causing them to remain in place even after removal of the stamp. The curing may also, or additionally, chemically strengthen or alter the replication features 112a, 112b, causing them to withstand more strongly subsequent etching steps that are not intended to etch the replication material.

FIGS. 1A-1P show features in a side view, such that three-dimensional shapes of the features are not differentiated. In various implementations, replication features can have any of a variety of shapes. For example, replication features can include columns having circular, rectangular, or otherwise-shaped perimeters. Moreover, these shapes of the replication features correspond to resulting substrate features. For example, an imprinted replication feature that is a hexagonal column will lead to a hexagonal, columnar substrate feature. Different shapes of replication features can be combined to produce complex, multi-level substrate structures.

As shown in FIG. 1C, the residual layer 116 (if present) is removed. This may be performed using an etch selective to the replication material compared to the hard mask material. This etch can be configured to be short and/or to have a low etch rate, so as to remove the residual layer 116 while not removing significant amounts of the replication features 112a, 112b. In some implementations, this etch removes significant amounts of the replication features 112a, 112b, but leaves at least a portion of etch replication feature 112a, 112b in place and leaves replication feature 112b taller than replication feature 112a.

The type of etch used to remove the replication material (including the residual layer 116) selectively compared to the hard mask material depends on the specific types of those materials. In some implementations, this etch includes a plasma etch, e.g., an oxygen plasma etch. For example, the replication material may be etched using directional oxygen plasma using a high-vacuum tool or a barrel asher. In some implementations, a wet chemical etch is used. Replication material etches may have etch rates in the range of 0.5 nm/sec to 20 nm/sec, or another value.

In some implementations, the etch used to remove the replication material selectively is selective to the replication material compared to the spacer material and/or the substrate.

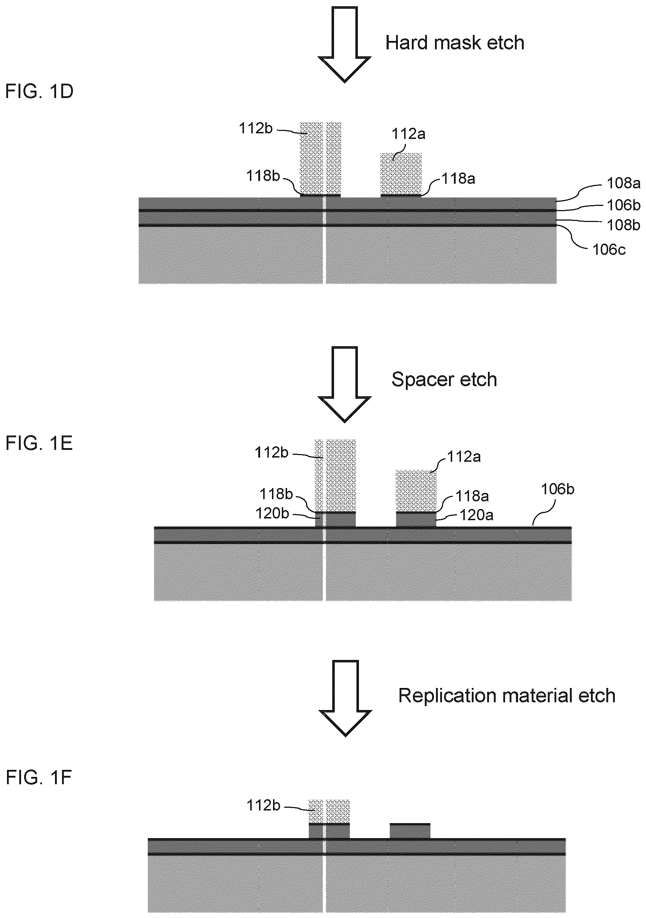

As shown in FIG. 1D, hard mask layer 106a is etched. This etch is selective to the hard mask material compared to the spacer material and compared to the replication material, such that the etch substantially terminates at spacer layer 108a and leaves replication material in place in the replication features 112a, 112b. Portions 118a, 118b of the hard mask layer 106a that are aligned with positions of the replication features 112a, 112b are masked by the replication features 112a, 112b and are correspondingly not significantly removed by the etch.

The type of etch used to remove the hard mask material selectively compared to the spacer material and the replication material depends on the specific types of those materials. For example, when the hard mask material includes chromium, the hard mask layer may be etched by a wet etch based on ceric ammonium nitrate. In some implementations, a plasma etch is used to etch the hard mask material, e.g., an inductively-coupled plasma etch with a chlorine/oxygen gas mixture. Metal hard mask materials may be plasma-etched using a chlorine-based chemistry, and metal oxide hard mask materials may be plasma-etched in a chlorine-based or fluorine-based chemistry. In some implementations, the hard mask material is etched using reactive ion etching and/or ion beam etching.

In some implementations, the etch used to remove the hard mask material selectively is selective to the hard mask material compared to the substrate.

As shown in FIG. 1E, spacer layer 108a is etched. This etch is selective to the spacer material compared to the hard mask material and compared to the replication material, such that the etch substantially terminates at hard mask layer 106b and leaves replication material in place in the replication features 112a, 112b. Portions 120a, 120b of the spacer layer 108a that are aligned with positions of the replication features 112a, 112b are masked by the replication features 112a, 112b and by remaining portions 118a, 118b of hard mask layer 106a, such that these portions 120a, 120b are correspondingly not significantly removed by the etch.

The type of etch used to remove the spacer material selectively compared to the hard mask material and the replication material depends on the specific types of these materials. In some implementations, the spacer material includes photoresist, and the spacer layer is etched by a wet etch in acetone or a specialized photoresist stripping solution. In some implementations, the spacer material includes an oxide, and the spacer layer is etched by a wet etch in an acid (e.g., hydrofluoric acid). In some implementations, the spacer material is etched by a plasma etch including a fluorine-based chemistry, e.g., a C₄F₈/SF₆ etch, a CHF₃/SF₆/BCl₃ etch, or an O₂/SF₆ etch, or another etch type.

In some implementations, the selective spacer material etch is selective to the spacer material compared to the substrate material.

As shown in FIG. 1F, the replication material is etched selectively to remove replication feature 112a. This etch is timed such that only a portion of replication feature 112b is removed. For example, if replication feature 112a is 500 nm tall, replication feature 112b is 1000 nm tall, and the etchant used to etch replication material etches at a rate of 20 nm/sec, then this etching step could involve a 30 second etch, to remove all of replication feature 112a and leave 400 nm of replication feature 112b in place.

This etch can be performed, for example, using an etching process as described in reference to FIG. 1C, or another etching process.

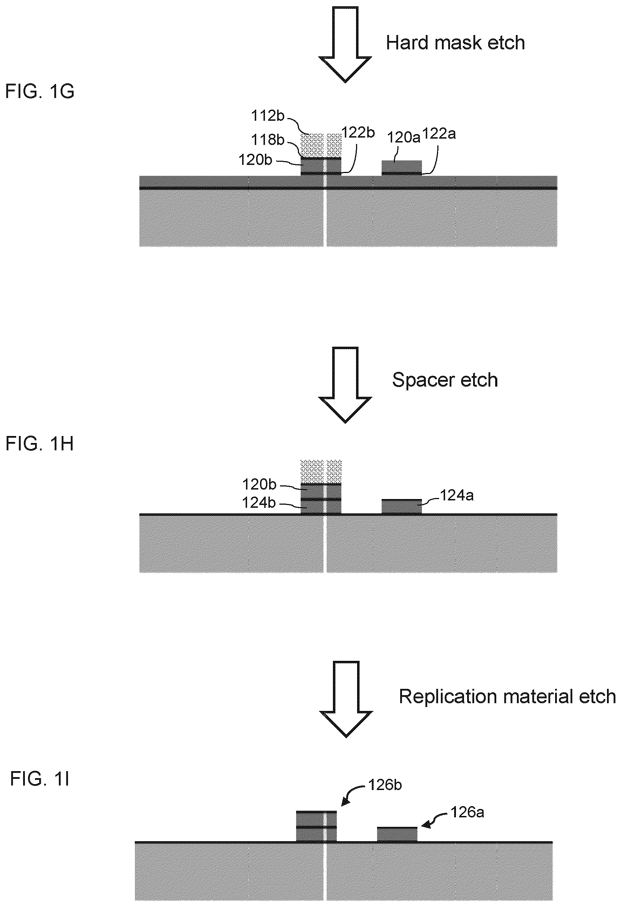

As shown in FIG. 1G, a selective hard mask layer etch is performed, e.g., as described in reference to FIG. 1D. This etch removes portion 118a of the hard mask layer 106a (no longer masked by replication material) along with areas of hard mask layer 106b. Portion 118b of the hard mask layer 106a is still masked by replication feature 112b and so is not significantly etched. Portions 122a, 122b of hard mask layer 106b are masked at least by, respectively, portions 120a, 120b of spacer layer 108a, and so similarly are not significantly etched.

As shown in FIG. 1H, a selective spacer etch is performed, e.g., as described in reference to FIG. 1E. This etch removes portion 120a of spacer layer 108a (no longer masked by hard mask material or replication material) along with areas of spacer layer 108b. Portion 120b of spacer layer 108a and portions 124a, 124b of spacer layer 108b are masked by hard mask material and/or replication material and are therefore not significantly etched.

As shown in FIG. 1I, a selective replication material etch is performed, as described in reference to FIG. 1C. This etch removes the remainder of replication feature 112b. In this example process, there are replication features of only two different heights, and so this etch results in the removal of all remaining replication material. However, various implementations can include replication features of one, three, four, or more different heights, such that the etch to remove a second-shortest replication feature is configured such that other replication features remain after the etch, as described above in reference to FIG. 1F.

At the process stage shown in FIG. 1F, the replication material has been removed. However, the replication features 112a, 112b defined by imprinting have resulted in corresponding structures being formed in the multi-layer structure 102. A remaining portion 126a of the multi-layer structure 102 is aligned with a (former) position of replication feature 112a, and another remaining portion 126b of the multi-layer structure 102 is aligned with a (former) position of replication feature 112b. Portion 126a includes one meta-layer and is thinner than portion 126b, which includes two meta-layers. The relative thicknesses/number of meta-layers in these portions 126a, 126b corresponds qualitatively to the relative heights of the replication features 112a, 112b: because replication feature 112b is thicker, some of replication feature 112b remains in place after replication feature 112a is fully etched away, and the remaining portion of replication feature 112b can act as an etch mask to protect more meta-layers of the multi-layer structure 102 from subsequent etches.

"Aligned," as used in this disclosure, can refer at least to the relative lateral positions of features with respect to a substrate surface on which the multi-layer structure is disposed. Each replication feature is aligned with a corresponding column of multi-layer structure and substrate that lie directly beneath the replication feature. A first structure and a second structure can be said to be "aligned" even if the first structure has been removed; in this case, the second structure is aligned with a former position of the first structure.

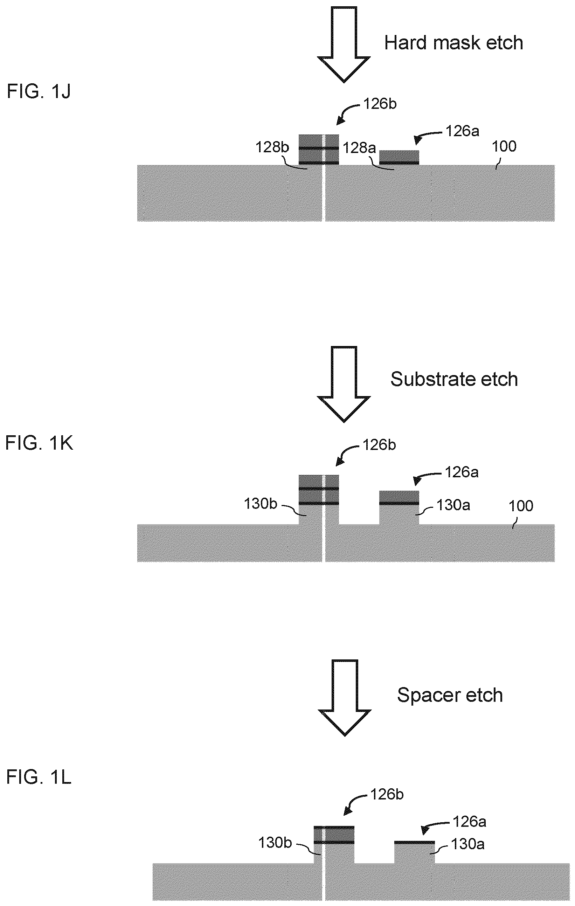

As shown in FIG. 1J, a selective hard mask layer etch is performed, e.g., as described in reference to FIG. 1D. This etch removes sections of hard mask layer 106c to expose underlying sections of substrate 100. Portions 128a, 128b of the substrate are masked, respectively, by overlying layers of remaining portions 126a, 126b of the multi-layer structure 102, and are therefore not significantly etched.

As shown in FIG. 1K, the substrate is etched selectively with respect to the spacer material. In some implementations, the substrate etch is selective with respect to the hard mask material. This etching creates two intermediate substrate features 130a, 130b based on masking by remaining portions 126a, 126b of the multi-layer structure 102.

The type of etch used to selectively remove the substrate compared to the spacer material and/or the hard mask material depends on the specific types of these materials. In some implementations, the substrate is a silicon substrate, and the selective substrate etch includes a KOH etch or another selective silicon wet etch. In some implementations, the selective substrate etch includes a plasma etch. For example, the plasma etch may include a fluorine-based chemistry such as a C₄F₈/SF₆ etch, a CHF₃/SF₆/BCL₃ etch, or an O₂/SF₆ etch.

Fluorine-based plasma etches may be particularly useful when a material (replication material, hard mask material, spacer material, or substrate material) includes silicon.

The intermediate substrate features 130a, 130b, which at this point in the fabrication process have the same height, are aligned with former positions of the replication features 112a, 112b and have thicknesses of multi-layer structure above them that corresponding to different heights of the imprinted replication features 112a, 112b. Equivalently, the intermediate substrate features 130a, 130b have different numbers of spacer layers above them (one and two, respectively), corresponding to relative heights of the imprinted replication features 112a, 112b. In some implementations, meta-layers are defined such that the intermediate substrate features 130a, 130b have different numbers of meta-layers above them (e.g., one and two, respectively).

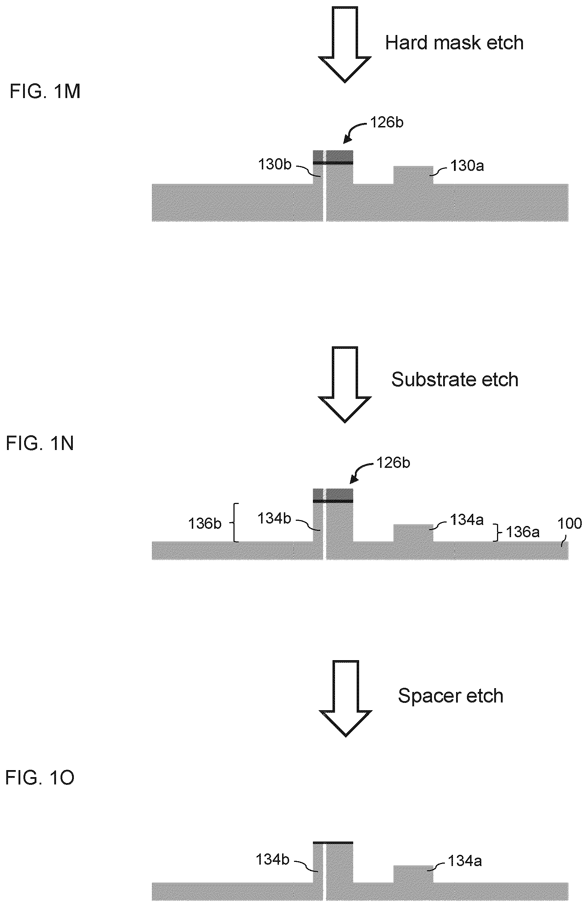

FIGS. 1L and 1M show results of a selective spacer etch followed by a selective hard mask etch, e.g., as described in reference to FIGS. 1D-1E. Together, these etches remove the remaining portions of the multi-layer structure 102 that were masking intermediate substrate feature 130a (aligned with a former position of replication feature 112a), while portions of spacer layer 108b and 106c remain masking intermediate substrate feature 130b (aligned with a former position of replication feature 112b).

As shown in FIG. 1N, a selective substrate etch is performed, e.g., as described in reference to FIG. 1K. This etch etches unmasked portions of the substrate 100, including intermediate substrate feature 130a; intermediate substrate feature 130b is masked by the remaining portion 126b of the multi-layer structure 102 and is not significantly etched. Substrate features 134a and 134b, having different respective heights 136a, 136b, are produced by this etch. These substrate features 134a, 134b represent the desired multi-level structure.

Because intermediate substrate feature 130a is exposed to this second selective substrate etch along with surrounding portions of the substrate 100, the height 136a of substrate feature 134a matches or substantially matches a height of the intermediate substrate feature 130a. By contrast, because intermediate substrate feature 130b is masked during the second selective substrate etch while surrounding portions of the substrate 100 are not, substrate feature 134b is taller than intermediate substrate feature 130b. A duration of this etch determines the difference between substrate feature heights 136a and 136b.

Substrate features 134a, 134b are aligned, respectively, with replication features 112a, 112b, and have relative heights corresponding to the relative heights of replication features 112a, 112b. The initial imprinted replication features 112a, 112b have therefore led directly (through a sequence of selective etch steps) to corresponding features in the high refractive index substrate 100. It can be appreciated that appropriate selection of the multi-layer structure (e.g., a number of meta-layers included in the multi-layer structure) and appropriate configuration of the initial imprinting (which can be performed at relatively low-cost and with a high degree of flexibility based on the imprinting stamp/mold), followed by appropriate etch steps that, in some implementations, need not change appreciably based on variation in the formed replication features, can lead to an essentially unlimited variety of multi-level structures, subject to the conditions imposed in this example by the two-meta-layer multi-layer structure 102. For example, shapes of replication features will result in corresponding shapes of substrate features, and relative heights of replication features will result in corresponding relative heights of substrate features. Therefore, a high degree of process flexibility can be achieved.

Moreover, some or all of the selective etches may be relatively simple, low-cost, and/or rapid etches compared to other etches capable of forming multi-level structures in semiconductor substrate, e.g., Bosch deep reactive ion etches.

In addition, the material types of the spacer layers and hard mask layers can be selected in conjunction with etch methods for anisotropic, highly selective etching with precise pattern transfer from the replication features to the substrate features.

Subject to other limitations (e.g., non-ideal etch selectivities, mechanical limitations, substrate thickness, or other constraints), the processes described in this disclosure can lead to almost any desired height of substrate features and almost any desired difference in heights of substrate features. In this example, the height 136a of substrate feature 134a is set substantially or entirely by the first substrate etch described in reference to FIG. 1K (e.g., by a duration and etch rate of the etch). The height 136b of substrate feature 134b is set substantially or entirely by the second substrate etch described in reference to FIG. 1N, subject to the minimum height already imposed by the first substrate etch.

The heights 136a, 136b of the substrate features can depend, among other possible factors, on a desired function of the multi-level structure, on a material of the multi-level structure (e.g., a refractive index of the substrate material), and on lateral dimensions of the substrate features. When the multi-level structure has an optical functionality, the heights 136a, 136b may be similar to a wavelength of light on which the multi-level structure is configured to operate. For example, when the multi-level structure is integrated into a visible-light device, the heights 136a, 136b may be between 400 nm and 1000 nm. When the multi-level structure is integrated into a near infrared-light device, the heights 136a, 136b may be between 500 nm and 4000 nm. In some implementations, heights of substrate features are between 50 nm and 5000 nm.

In some implementations, a difference between heights of substrate features (e.g., a difference between heights 136a and 136b) is less than a wavelength of interest. In some implementations (e.g., when the multi-level structure is configured to interact with visible light), the height difference between a first substrate feature and a second substrate feature is between about 50 nm and 500 nm.

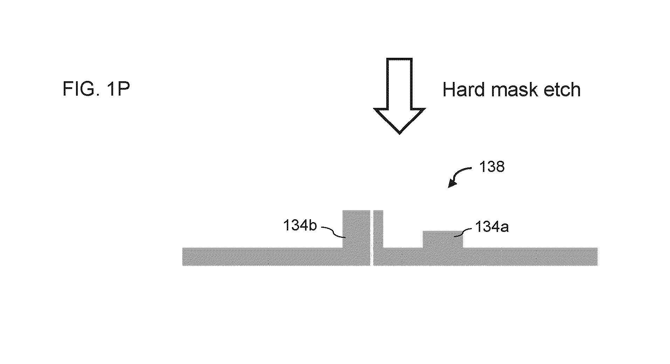

Optionally, as shown in FIGS. 1O and 1P, additional selective spacer layer and hard mask layer etches (e.g., as described in reference to FIGS. 1D-1E) can be performed to fully remove the multi-layer structure 102, leaving only the multi-level substrate structure 138 that includes substrate features 134a and 134b. The multi-layer substrate structure 138 may perform functions, for example, of an optical metastructure (e.g., a metalens) or a diffractive optical element, and/or may perform other functions. For example, the multi-layer substrate structure 138 may perform an electrical function (by itself or by integration with other components), may form microfluidic structures, and/or perform other functions.

In some implementations, each type of selective etch described in this disclosure (e.g., selective hard mask layers etches) is the same throughout a fabrication process. However, in some implementations, different etches or etch conditions (e.g., different chemicals and/or different chemical concentrations) may be used for different etches of a given type during a fabrication process.

In addition, etch steps need not be performed in the order and/or combination described in reference to FIGS. 1A-1P. For example, in some implementations a selective substrate etch is preceded by, rather than followed by, a spacer etch, with a hard mask layer (rather than a hard mask layer and a spacer layer) providing masking at a thinnest portion of the remaining multi-layer structure. In some implementations, two or more etch steps can be combined or performed simultaneously or at overlapping times.

In addition, multi-layer structures may include layers not shown in FIG. 1A, and/or may include layers in a different combination or order. For example, in some implementations a top layer or bottom layer of the multi-layer structure is a spacer layer rather than a hard mask layer.

The example multi-layer structure 102 shown in FIG. 1A includes two meta-layers (two spacer layers and three hard mask layers). In some implementations, a number of these meta-layers corresponds to a number of possible different heights of resulting substrate features, because each different substrate feature height corresponds to masking by a different respective combination of meta-layers. Multi-layer structures can include any number of meta-layers to produce multi-level structures with an equal or smaller number of substrate feature heights.

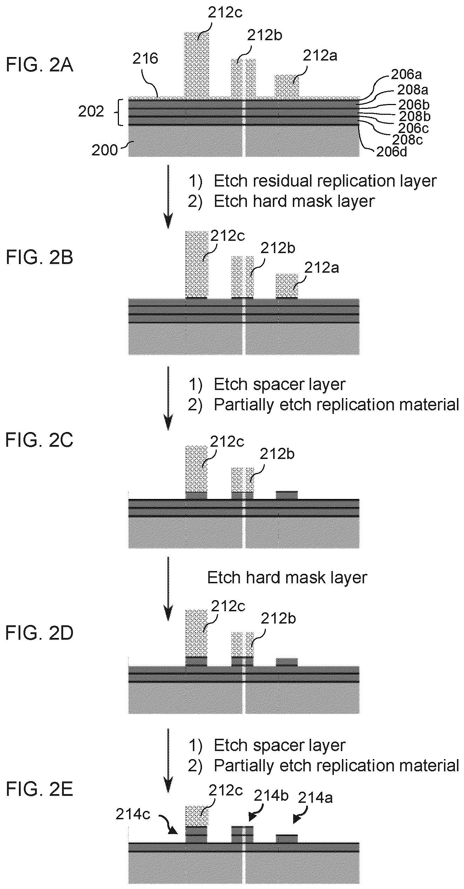

In accordance with this principle, FIGS. 2A-2C show an example fabrication process for a three-level substrate structure, based on a multi-layer structure having three layers. For conciseness, some portions of this process are not shown by a separate drawing. Unless indicated otherwise, the described layers, materials, processes, and etches may have the characteristics and relationships described for corresponding layers, materials, processes, and etches described in reference to FIGS. 1A-1P.

As shown in FIG. 2A, replication material is imprinted to form three replication features 212a, 212b, 212c having different respective heights. Replication feature 212c is taller than replication feature 212b, which is taller than replication feature 212a. In this example, a residual layer 216 of replication material remains in place. The replication material is disposed on a multi-layer structure 202 that includes three meta-layers, each meta-layer including a spacer layer and a hard mask layer. In total, the multi-layer structure 202 includes three spacer layers and four hard mask layers. The multi-layer structure 202 is disposed on a substrate 200.

The three spacer layers include a top spacer layer 208a, a middle spacer layer 208b, and a bottom spacer layer 208c. The four hard mask layers include a first hard mask layer 206a, a second hard mask layer 206b, a third hard mask layer 206c, and a fourth hard mask layer 206d.

As shown in FIG. 2B, the residual layer 216 of replication material is etched away (e.g., as described in reference to FIG. 1C), and the top hard mask layer 206a is etched away except for portions masked by replication features 212a, 212b, 212c (e.g., as described in reference to FIG. 1D).

As shown in FIG. 2C, the top spacer layer 208a is etched away except for portions masked by the top hard mask layer 206a and replication features 212a, 212b, 212c (e.g., as described in reference to FIG. 1E). The replication material is partly etched, such that replication feature 212a is removed and portions of replication features 212b, 212c are removed (e.g., as described in reference to FIG. 1F).

As shown in FIG. 2D, the first hard mask layer 206a and the second hard mask layer 206b are etched away except for masked portions (e.g., as described in reference to FIG. 1D. As shown in FIG. 2E, the top spacer layer 208a and the middle spacer layer 208b are etched away except for masked portions (e.g., as described in reference to FIG. 1E). As a result of this, the section 214a of the multi-layer structure 202 aligned with the former position of etched-away replication feature 212a is thinner than and includes one fewer meta-layers than sections 214b, 214c of the multi-layer structure aligned with the position of the preserved replication features 212b, 212c.

As also shown in FIG. 2E, the replication material is partly etched, such that replication feature 212b is removed and portions of replication features 212c are removed (e.g., as described in reference to FIG. 1F).

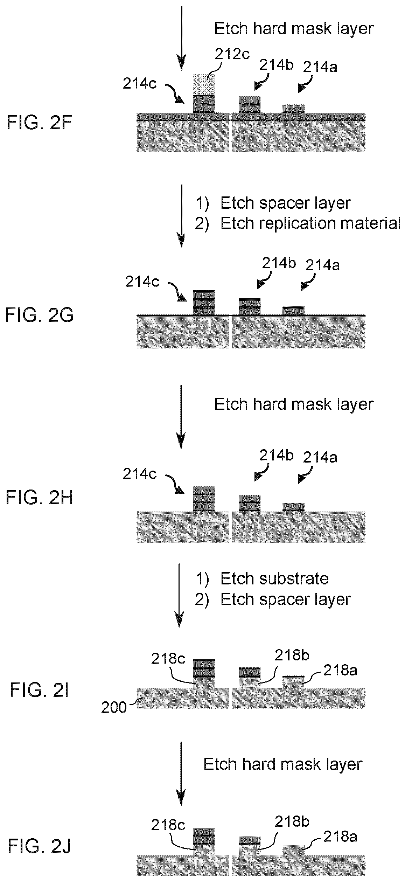

As shown in FIG. 2F, the first, second, and third hard mask layers 206a, 206b, 206c are etched away except for masked portions (e.g., as described in reference to FIG. 1D). As shown in FIG. 2G, the top spacer layer 208a, the middle spacer layer 208b, and the bottom spacer layer 208c are etched away except for masked portions (e.g., as described in reference to FIG. 1E). As a result, the section 214a of the multi-layer structure 202 aligned with a position of the shortest replication feature 212a is thinner than and includes one fewer meta-layers than the section 214b of the multi-layer structure 202 aligned with a position of the middle-height replication feature 212b. Also, the section 214b of the multi-layer structure 202 aligned with the position of the middle-height replication feature 212b is thinner than and includes one fewer meta-layers than the section 214c of the multi-layer structure 202 aligned with a position of the tallest replication feature 212c. Therefore, relative heights of the imprinted replication features 212a, 212b, 212c have been transferred to corresponding relative heights/meta-layer counts of the multi-layer structure 202.

As also shown in FIG. 2G, the remaining replication material (i.e., remaining portions of the replication feature 212c) are etched away (e.g., as described in reference to FIG. 1C).

As shown in FIG. 2H, the first, second, third, and fourth hard mask layers 206a, 206b, 206c, 206d are etched away except for masked portions (e.g., as described in reference to FIG. 1D).

As shown in FIG. 2I, the substrate 200 is partially etched in a first substrate etch to form three first intermediate substrate features 218a, 218b, 218c defined by remaining masking portions of the multi-layer structure 202 (e.g., as described in reference to FIG. 1K). This etch defines a height of substrate feature 224a that will result from the fabrication process. As also shown in FIG. 2I, the top, middle, and bottom spacer layers 208a, 208b, 208c are etched away except for masked portions (e.g., as described in reference to FIG. 1E).

As shown in FIG. 2J, the second, third, and fourth hard mask layers 206a, 206b, 206c are etched away except for masked portions (e.g., as described in reference to FIG. 1D).

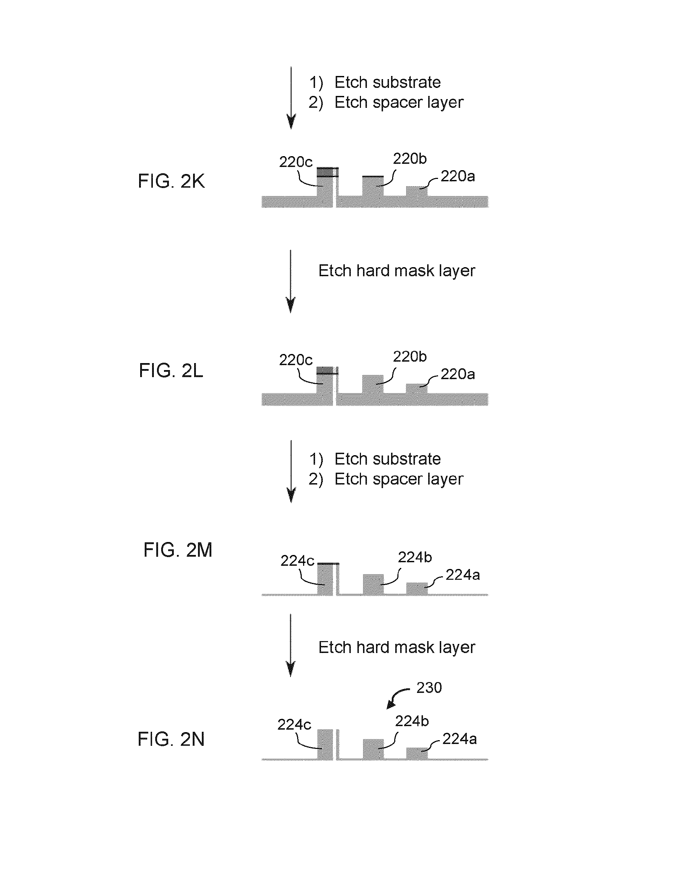

As shown in FIG. 2K, a second substrate etch is performed to form three second intermediate substrate features 220a, 220b, 220c based on the masking of first intermediate substrate features 218b, 218c and the lack of masking of first intermediate substrate feature 218a (e.g., as described in reference to FIG. 1K). This etch in combination with the first substrate etch defines a height of substrate feature 224b that will result from the fabrication process. As also shown in FIG. 2K, the middle and bottom spacer layers 208b, 208c are etched away except for a masked portion (e.g., as described in reference to FIG. 1E).

As shown in FIG. 2L, the third and fourth hard mask layers 206c, 206d are etched away except for a masked portion (e.g., as described in reference to FIG. 1D).

As shown in FIG. 2M, a third substrate etch is performed to form substrate features 224a, 224b, 224c based on the masking of first intermediate substrate feature 218c and the lack of masking of first intermediate substrate features 218a, 218b (e.g., as described in reference to FIG. 1K). This etch in combination with the first two substrate etches defines a height of substrate feature 224c. As also shown in FIG. 2M, remaining spacer material is etched away (e.g., as described in reference to FIG. 1E).

As shown in FIG. 2N, remaining hard mask material is etched away (e.g., as described in reference to FIG. 1D).

The resulting multi-level structure 230 includes substrate features 224a, 224b, 224c having three different heights, corresponding to the three different heights of the replication features 212a, 212b, 212c with which the substrate features 224a, 224b, 224c are respectively aligned and also corresponding to the three meta-layers included in the multi-layer structure 202. Both meta-layer count and number of imprinted heights can be increased to allow for more heights in the final multi-level structure.

In some implementations according to this disclosure, an overall fabrication process can include two or more sub-processes that correspond to different combinations of etches. In some instances, the some of the sub-processes may at least partially overlap with one another.

For example, in some implementations a first sub-process includes i) partially etching replication material to remove a first replication feature without fully removing a second replication feature, ii) etching away a portion of an underlying hard mask layer, and iii) etching away a portion of an underlying spacer layer. Examples of this sub-process are shown, for example, in FIGS. 1E-1H, 2B-2E, and 2D-2G. As a result of this sub-process, a column of multi-layer structure aligned with a position of the first replication feature is made to include one fewer meta-layers than a column of multi-layer structure aligned with a position of the second replication structure.

In some implementations, a second sub-process includes i) performing a selective spacer etch, ii) performing a selective hard mask etch to cause a first portion of substrate to be exposed while a second portion of substrate is still masked, and iii) performing a selective substrate etch. Examples of this sub-process are shown, for example, in FIGS. 1K-1N, 2I-2K, and FIGS. 2K-2M. As a result of this sub-process, the first portion of the substrate is etched while the second portion of the substrate is not, leading to corresponding different substrate feature heights.

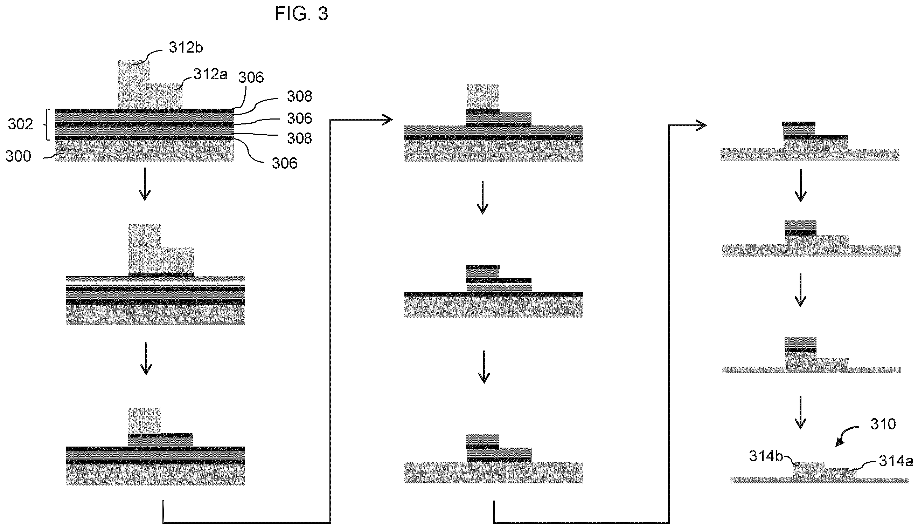

FIG. 3 shows another example of fabrication of a multi-layer structure in a substrate. In this example, imprinted replication features are adjoining, which results in adjoining substrate features in a fabricated multi-level structure.

The example process of FIG. 3 is performed as described for the example process of FIGS. 1A-1P, except where indicated otherwise. Two adjoining replication features 312a, 312b of different heights are formed on a two-meta-layer multi-layer structure 302 disposed on a substrate 300. The multi-layer structure 302 includes three hard mask layers 306 and two spacer layers 308.

As described in reference to FIGS. 1A-1P, a sequence of etching steps is performed, as shown in stages in FIG. 3. The sequence of etching steps includes selective replication material etches as described in reference to FIG. 1C, selective hard mask material etches as described in reference to FIG. 1D, selective spacer material etches as described in reference to FIG. 1E, and selective substrate etches as described in reference to FIG. 1K. These etching steps result in the fabrication of a multi-level structure 310 in the substrate 300, the multi-level structure 310 including substrate features 314a, 314b having different heights. Because substrate features are aligned with positions of corresponding replication features, in this example the substrate features 314a, 314b are adjoining as were the replication features 312a, 312b. As described throughout this disclosure, relative heights of the replication features 312a, 312b correspond to relative heights of the substrate features 314a, 314b.

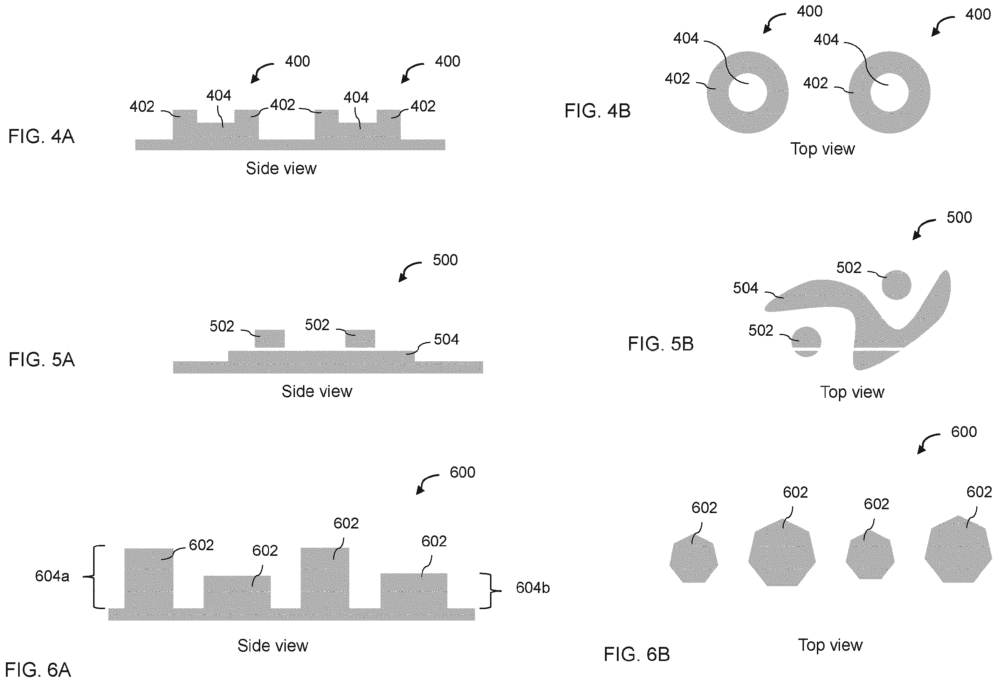

Different shapes, combinations, and heights of replication features correspond to different shapes, combinations, and heights of resulting substrate features after the performance of etching steps. FIGS. 4-6 show respective side and top views of multi-level substrate structures that can be fabricated according to implementations of this disclosure.

FIGS. 4A-4B show donut-shaped multi-level structures 400 with higher outer portions 402 and lower inner portions 404. These structures may be fabricated as a result of etching processes starting with two-level donut-shaped replication features, e.g., donut-shaped replication features with higher outer annular portions and lower enclosed inner portions corresponding to the multi-level structures 400. A stamp to imprint each replication structure might include an annular recess, a first protrusion inside the annular recess, and a second protrusion, extending out further than the first protrusion, surrounding the annular recess.

FIGS. 5A-5B show two elevated pillars 502 and a freeform shape 504, at a lower elevation than the two elevated pillars 502, that together form an overall multi-level structure 500. To form the multi-level structure 500, a layer of replication material can be imprinted with a stamp having two round recesses (to make two cylindrical replication features corresponding to the two elevated pillars 502) and a third recess that is less recessed than the two round recesses and has a shape matching the shape of the freeform shape 504. The resulting replication features are disposed on a multi-layer structure having at least two meta-layers, and a series of etching processes are carried out as described throughout this disclosure.

FIGS. 6A-6B show a multi-level structure 600 including four substrate features 602 of two heights 604a, 604b. Each substrate feature 602 is a seven-sided pillar. To form the multi-level structure 600, a layer of replication material may be imprinted with a stamp having four seven-sided recesses of two different depths corresponding to the two heights 604a, 604b, so as to imprint four seven-sided replication features. The resulting replication features are disposed on a multi-layer structure having at least two meta-layers, and a series of etching processes are carried out as described throughout this disclosure.

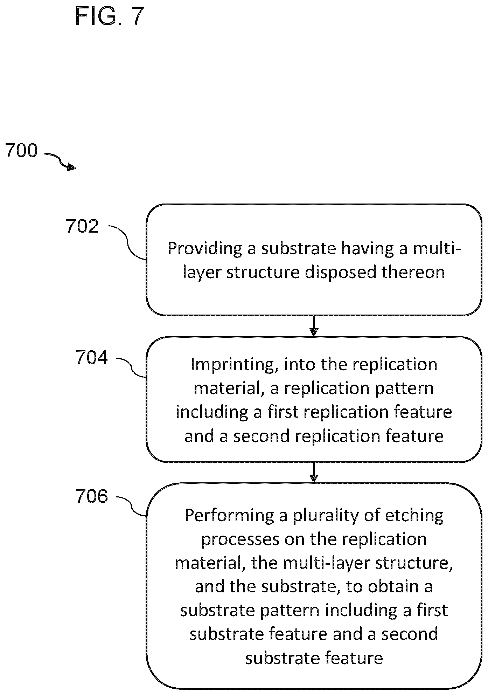

FIG. 7 shows an example process 700 in accordance with some implementations of this disclosure.

A substrate is provided having a multi-layer structure disposed thereon (702). The multi-layer structure includes a plurality of meta-layers, each meta-layer including a hard mask layer including a hard mask material, and a spacer layer on which the hard mask layer is disposed, the spacer layer including a spacer material. A replication material is disposed on a surface of the multi-layer structure.

A replication pattern including a first replication feature and a second replication feature is imprinted into the replication material (704). The first replication feature and the second replication feature have different heights.

A plurality of etching processes are performed on the replication material, the multi-layer structure, and the substrate, to obtain a substrate pattern including a first substrate feature and a second substrate feature (706). The first substrate feature is aligned with a position of the first replication feature and the second substrate feature is aligned with a position of the second replication feature. The first substrate feature and the second substrate feature have different heights.

The multi-level structures formed can have various functionalities. For example, the multi-level structures (e.g., including meta-layers) can form some or all of an optical structure that acts as a meta-optical element or a diffractive optical element such as a lens, lens array, beam splitter, diffuser, polarizer, bandpass filter, or other optical element. In some implementations, the multi-level structure can perform an anti-reflection functionality. For example, the multi-level structure may provide a metastructure that includes a surface with a distributed array of nanostructures or other meta-atoms that individually or collectively, interact with light waves to change a local amplitude, a local phase, or both, of an incoming light wave. In some implementations, the multi-level structure provides a diffractive optical element (DOE) that is operable to modify an incident light's phase and/or amplitude to create a desired optical output pattern with a specified functionality. The multi-level structures can be included, for example, in optical devices and modules, e.g., devices and modules to produce one or more of structured light, diffused light, or patterned light. The devices and modules may be part of, for example, time-of-flight cameras or active-stereo cameras. The devices and modules may be integrated into systems, for example, mobile phones, laptops, television, wearable devices, or automotive vehicles.

When the multi-level structure provides an optical functionality, in some implementations a relatively high refractive index of the multi-level structure compared to typical refractive indices of replication materials may provide improved optical functionality.

In some implementations, the multi-level structure can provide a hydrophilic or hydrophobic functionality. Other types of structures and functionalities can also be formed or provided.

In this disclosure, references to refractive indices refer to values of these properties at room temperature (e.g., 25°C).

Therefore, in accordance with the implementations of this disclosure, the fabrication of multi-level structures is described.

Various modifications will be apparent from the foregoing detailed description. Further, features described above in connection with different implementations may, in some cases, be combined in the same implementation. In some instances, the order of the process steps may differ from that described in the particular examples above.

Accordingly, other implementations are also within the scope of the claims.

## Claims

1. A method comprising:
providing a substrate (100, 200, 300) having a multi-layer structure (102, 202, 302) disposed thereon (702), wherein the multi-layer structure comprises a plurality of meta-layers (110a, 110b), each meta-layer comprising
a hard mask layer (106a, 106b, 206a, 206b, 206c, 306) comprising a hard mask material, and
a spacer layer (108a, 108b, 208a, 208b, 208c, 308) on which the hard mask layer is disposed, the spacer layer comprising a spacer material, and
wherein a replication material (104) is disposed on a surface of the multi-layer structure;
imprinting, into the replication material, a replication pattern (704) comprising a plurality of replication features (112a, 112b, 212a, 212b, 212c, 312a, 312b) having different respective heights (114a, 114b) from one another; and
performing a plurality of etching processes on the replication material, the multi-layer structure, and the substrate, to obtain a substrate pattern comprising a plurality of substrate features (706), wherein each respective substrate feature (134a, 134b, 224a, 224b, 224c, 314a, 314b, 602) is aligned with a position of a respective one of the replication features, wherein the substrate features have different respective heights (136a, 136b, 604a, 604b) from one another, and wherein a number of the plurality of meta-layers equals or is greater than the number of different heights for the substrate features formed by the plurality of etching processes.

2. The method of claim 1, the plurality of replication features includes a first replication feature and a second replication feature, and wherein a height of the first replication feature is smaller than a height of the second replication feature, and wherein the plurality of etching processes comprises a first etching process comprising:
etching the replication material until the first replication feature is removed and a portion of the second replication feature remains on the multi-layer structure.

3. The method of claim 2, wherein the plurality of etching processes comprises a second etching process, performed after the first etching process, the second etching process comprising:
etching away a portion of a hard mask layer of a first meta-layer (110a), the etched-away portion of the hard mask layer aligned with the position of the first replication feature; and
etching away a portion of a spacer layer of the first meta-layer, the etched-away portion of the spacer layer aligned with the position of the first replication feature and with a position of the etched-away portion of the hard mask layer of the first meta-layer.

4. The method of claim 3, wherein the second etching process causes a portion of the multi-layer structure aligned with the position of the first replication feature to include fewer meta-layers than a portion of the multi-layer structure aligned with the position of the second replication feature, and/or wherein the second etching process causes a portion of the multi-layer structure aligned with the position of the first replication feature to be thinner than a portion of the multi-layer structure aligned with the position of the second replication feature.

5. The method of claim 1, wherein a first part of the plurality of etching processes causes the multi-layer structure to include a first portion and a second portion, the first portion thinner than the second portion, and wherein a second part of the plurality of etching processes comprises:
etching the substrate to form a first intermediate substrate feature (130a, 130b, 218a, 218b, 218c) and a second intermediate substrate feature (130a, 130b, 218a, 218b, 218c), wherein the first intermediate substrate feature is aligned with the position of the first portion of the multi-layer structure and the second intermediate substrate feature is aligned with the position of the second portion of the multi-layer structure.

6. The method of claim 5, comprising, subsequent to etching the substrate to form the first and second intermediate substrate features:
etching away the first portion of the multi-layer structure to expose the first intermediate substrate feature and to leave in place at least some of the second portion of the multi-layer structure; and
etching away a portion of the first intermediate substrate feature, the second intermediate substrate feature being protected from etching by the second portion of the multi-layer structure; wherein the method optionally comprises, subsequent to etching away the portion of the first intermediate substrate feature
etching away at least some of the second portion of the multi-layer structure, and
etching the substrate to form the first substrate feature and the second substrate feature.

7. The method of claim 1, comprising, subsequent to imprinting the replication pattern, etching away a residual layer (116, 216) of the replication material remaining on the surface of the multi-layer structure.

8. The method of claim 1, wherein the hard mask material is a metal or a metal oxide, optionally wherein the hard mask material comprises chromium.

9. The method of claim 1, wherein the spacer material comprises at least one of a photoresist, an oxide, or a nitride, and/or wherein the replication material comprises at least one of a polymer, an epoxy, or a resin.

10. The method of claim 1, wherein the plurality of etching processes comprises:
a first etch that selectively etches the replication material compared to the hard mask material;
a second etch that selectively etches the hard mask material compared to the spacer material; and
a third etch that selectively etches the spacer material compared to the hard mask material.

11. The method of claim 1, wherein the plurality of etching processes comprises an etch that selectively etches the substrate compared to the spacer material.

12. The method of claim 2, wherein the plurality of substrate features includes a first substrate feature and a second substrate feature, and wherein the first replication feature adjoins the second replication feature, and
wherein the first substrate feature adjoins the second substrate feature.

13. The method of claim 1, wherein the plurality of substrate features includes a first substrate feature and a second substrate feature, and wherein the first substrate feature and the second substrate feature together form some or all of an optical metastructure.

14. The method of claim 1, wherein the substrate has a refractive index of greater than 2.5 for at least one of ultraviolet light, visible light, or infrared light, and/or wherein imprinting the replication pattern comprises curing the replication material.

15. An apparatus comprising:
a substrate (100, 200, 300); and
a multi-layer structure (102, 202, 302) disposed on the substrate, the multi-layer structure comprising a plurality of meta-layers (110a, 110b), each meta-layer comprising
a hard mask layer (106a, 106b, 206a, 206b, 206c, 306) comprising a metal or a metal oxide, and
a spacer layer (108a, 108b, 208a, 208b, 208c, 308) on which the hard mask layer is disposed, the spacer layer comprising at least one of a photoresist, an oxide, or a nitride,
wherein the substrate includes intermediate substrate features (130a, 130b, 218a, 218b, 218c) having different respective numbers of meta-layers above the intermediate substrate features.

16. The apparatus of claim 15, wherein each hard mask layer has a thickness between 10 nm and 50 nm, and/or wherein each spacer layer has a thickness between 5 nm and 50 nm, and/or wherein each hard mask layer comprises chromium, and/or wherein the substrate has a refractive index of between 3.5 and 5.0 for at least one of infrared light, ultraviolet light, or visible light and/or wherein the substrate comprises a layer of a first material disposed on a substrate layer comprising a second material.

## Patentansprüche

1. Verfahren, umfassend:
Bereitstellen eines Substrats (100, 200, 300) mit einer darauf angeordneten (702) mehrschichtigen Struktur (102, 202, 302), wobei die mehrschichtige Struktur eine Vielzahl von Metaschichten (110a, 110b) umfasst, wobei jede Metaschicht umfasst:
eine harte Maskenschicht (106a, 106b, 206a, 206b, 206c, 306), die ein hartes Maskenmaterial umfasst, und
eine Abstandhalterschicht (108a, 108b, 208a, 208b, 208c, 308), auf der die harte Maskenschicht angeordnet ist, wobei die Abstandhalterschicht ein Abstandhaltermaterial umfasst, und
wobei ein Replikationsmaterial (104) auf einer Oberfläche der mehrschichtigen Struktur angeordnet ist;
Imprinting, in das Replikationsmaterial, eines Replikationsmusters (704), das eine Vielzahl von Replikationsmerkmalen (112a, 112b, 212a, 212b, 212c, 312a, 312b) mit unterschiedlichen jeweiligen Höhen (114a, 114b) zueinander umfasst; und
Durchführen einer Vielzahl von Ätzprozessen an dem Replikationsmaterial, der mehrschichtigen Struktur und dem Substrat, um ein Substratmuster zu erhalten, das eine Vielzahl von Substratmerkmalen (706) umfasst, wobei jedes jeweilige Substratmerkmal (134a, 134b, 224a, 224b, 224c, 314a, 314b, 602) mit einer Position eines jeweiligen der Replikationsmerkmale ausgerichtet ist, wobei die Substratmerkmale unterschiedliche jeweilige Höhen (136a, 136b, 604a, 604b) zueinander aufweisen, und wobei eine Anzahl der Vielzahl von Metaschichten gleich oder größer als die Anzahl unterschiedlicher Höhen für die Substratmerkmale ist, die durch die Vielzahl von Ätzprozessen gebildet werden.

2. Verfahren nach Anspruch 1, wobei die Vielzahl von Replikationsmerkmalen ein erstes Replikationsmerkmal und ein zweites Replikationsmerkmal beinhaltet, und wobei eine Höhe des ersten Replikationsmerkmals kleiner als eine Höhe des zweiten Replikationsmerkmals ist, und wobei die Vielzahl von Ätzprozessen einen ersten Ätzprozess umfasst, der umfasst:
Ätzen des Replikationsmaterials, bis das erste Replikationsmerkmal entfernt ist und ein Abschnitt des zweiten Replikationsmerkmals auf der mehrschichtigen Struktur verbleibt.

3. Verfahren nach Anspruch 2, wobei die Vielzahl von Ätzprozessen einen zweiten Ätzprozess umfasst, der nach dem ersten Ätzprozess durchgeführt wird, wobei der zweite Ätzprozess umfasst:
Wegätzen eines Abschnitts einer harten Maskenschicht einer ersten Metaschicht (110a), wobei der weggeätzte Abschnitt der harten Maskenschicht mit der Position des ersten Replikationsmerkmals ausgerichtet ist; und
Wegätzen eines Abschnitts einer Abstandhalterschicht der ersten Metaschicht, wobei der weggeätzte Abschnitt der Abstandhalterschicht mit der Position des ersten Replikationsmerkmals und mit einer Position des weggeätzten Abschnitts der harten Maskenschicht der ersten Metaschicht ausgerichtet ist.

4. Verfahren nach Anspruch 3, wobei der zweite Ätzprozess bewirkt, dass ein Abschnitt der mehrschichtigen Struktur, der mit der Position des ersten Replikationsmerkmals ausgerichtet ist, weniger Metaschichten beinhaltet als ein Abschnitt der mehrschichtigen Struktur, der mit der Position des zweiten Replikationsmerkmals ausgerichtet ist, und/oder wobei der zweite Ätzprozess bewirkt, dass ein Abschnitt der mehrschichtigen Struktur, der mit der Position des ersten Replikationsmerkmals ausgerichtet ist, dünner ist als ein Abschnitt der mehrschichtigen Struktur, der mit der Position des zweiten Replikationsmerkmals ausgerichtet ist.

5. Verfahren nach Anspruch 1, wobei ein erster Teil der Vielzahl von Ätzprozessen bewirkt, dass die mehrschichtige Struktur einen ersten Abschnitt und einen zweiten Abschnitt beinhaltet, wobei der erste Abschnitt dünner als der zweite Abschnitt ist, und wobei ein zweiter Teil der Vielzahl von Ätzprozessen umfasst:
Ätzen des Substrats, um ein erstes Zwischensubstratmerkmal (130a, 130b, 218a, 218b, 218c) und ein zweites Zwischensubstratmerkmal (130a, 130b, 218a, 218b, 218c) zu bilden, wobei das erste Zwischensubstratmerkmal mit der Position des ersten Abschnitts der mehrschichtigen Struktur ausgerichtet ist und das zweite Zwischensubstratmerkmal mit der Position des zweiten Abschnitts der mehrschichtigen Struktur ausgerichtet ist.

6. Verfahren nach Anspruch 5, umfassend, im Anschluss an das Ätzen des Substrats, um das erste und zweite Zwischensubstratmerkmal zu bilden:
Wegätzen des ersten Abschnitts der mehrschichtigen Struktur, um das erste Zwischensubstratmerkmal freizulegen und zumindest einen Teil des zweiten Abschnitts der mehrschichtigen Struktur an Ort und Stelle zu belassen; und
Wegätzen eines Abschnitts des ersten Zwischensubstratmerkmals, wobei das zweite Zwischensubstratmerkmal durch den zweiten Abschnitt der mehrschichtigen Struktur vor dem Ätzen geschützt wird;
wobei das Verfahren optional umfasst, im Anschluss an das Wegätzen des Abschnitts des ersten Zwischensubstratmerkmals,
Wegätzen zumindest eines Teils des zweiten Abschnitts der mehrschichtigen Struktur, und
Ätzen des Substrats, um das erste Substratmerkmal und das zweite Substratmerkmals zu bilden.

7. Verfahren nach Anspruch 1, umfassend, im Anschluss an das Imprinting des Replikationsmusters, Wegätzen einer Restschicht (116, 216) des Replikationsmaterials, das auf der Oberfläche der mehrschichtigen Struktur verbleibt.

8. Verfahren nach Anspruch 1, wobei das harte Maskenmaterial ein Metall oder ein Metalloxid ist, optional wobei das harte Maskenmaterial Chrom umfasst.

9. Verfahren nach Anspruch 1, wobei das Abstandhaltermaterial mindestens eines von einem Fotolack, einem Oxid oder einem Nitrid umfasst, und/oder wobei das Replikationsmaterial mindestens eines von einem Polymer, einem Epoxid oder einem Harz umfasst.

10. Verfahren nach Anspruch 1, wobei die Vielzahl von Ätzprozessen umfasst:
eine erste Ätzung, die das Replikationsmaterial im Vergleich zu dem harten Maskenmaterial selektiv ätzt;
eine zweite Ätzung, die das harte Maskenmaterial im Vergleich zu dem Abstandhaltermaterial selektiv ätzt; und
eine dritte Ätzung, die das Abstandhaltermaterial im Vergleich zu dem harten Maskenmaterial selektiv ätzt.

11. Verfahren nach Anspruch 1, wobei die Vielzahl von Ätzprozessen eine Ätzung umfasst, die das Substrat im Vergleich zu dem Abstandhaltermaterial selektiv ätzt.

12. Verfahren nach Anspruch 2, wobei die Vielzahl von Substratmerkmalen ein erstes Substratmerkmal und ein zweites Substratmerkmal beinhaltet, und wobei das erste Replikationsmerkmal an das zweite Replikationsmerkmal angrenzt, und
wobei das erste Substratmerkmal an das zweite Substratmerkmal angrenzt.

13. Verfahren nach Anspruch 1, wobei die Vielzahl von Substratmerkmalen ein erstes Substratmerkmal und ein zweites Substratmerkmal beinhaltet, und wobei das erste Substratmerkmal und das zweite Substratmerkmal zusammen einen Teil oder die Gesamtheit einer optischen Metastruktur bilden.

14. Verfahren nach Anspruch 1, wobei das Substrat einen Brechungsindex von größer als 2,5 für mindestens eines von Ultraviolettlicht, sichtbarem Licht oder Infrarotlicht aufweist, und/oder wobei das Imprinting des Replikationsmusters das Härten des Replikationsmaterials umfasst.

15. Einrichtung, umfassend:
ein Substrat (100, 200, 300); und
eine mehrschichtige Struktur (102, 202, 302), die auf dem Substrat angeordnet ist, wobei die mehrschichtige Struktur eine Vielzahl von Metaschichten (110a, 110b) umfasst, wobei jede Metaschicht umfasst:
eine harte Maskenschicht (106a, 106b, 206a, 206b, 206c, 306), die ein Metall oder ein Metalloxid umfasst, und
eine Abstandhalterschicht (108a, 108b, 208a, 208b, 208c, 308), auf der die harte Maskenschicht angeordnet ist, wobei die Abstandhalterschicht mindestens eines von einem Fotolack, einem Oxid oder einem Nitrid umfasst,
wobei das Substrat Zwischensubstratmerkmale (130a, 130b, 218a, 218b, 218c) mit unterschiedlichen jeweiligen Anzahlen von Metaschichten über den Zwischensubstratmerkmalen beinhaltet.

16. Einrichtung nach Anspruch 15, wobei jede harte Maskenschicht eine Dicke zwischen 10 nm und 50 nm aufweist, und/oder wobei jede Abstandhalterschicht eine Dicke zwischen 5 nm und 50 nm aufweist, und/oder wobei jede harte Maskenschicht Chrom umfasst, und/oder wobei das Substrat einen Brechungsindex zwischen 3,5 und 5,0 für mindestens eines von Infrarotlicht, Ultraviolettlicht oder sichtbarem Licht aufweist, und/oder wobei das Substrat eine Schicht aus einem ersten Material umfasst, die auf einer Substratschicht angeordnet ist, die ein zweites Material umfasst.

## Revendications

1. Procédé comprenant :
la fourniture d'un substrat (100, 200, 300) sur lequel est disposée une structure multicouche (102, 202, 302) (702), la structure multicouche comprenant une pluralité de métacouches (110a, 110b), chaque métacouche comprenant une couche de masque dur (106a, 106b, 206a, 206b, 206c, 306) comprenant un matériau de masque dur, et
une couche d'espacement (108a, 108b, 208a, 208b, 208c, 308) sur laquelle est disposée la couche de masque dur, la couche d'espacement comprenant un matériau d'espacement, et
un matériau de réplication (104) étant disposé sur une surface de la structure multicouche ;
l'impression, dans le matériau de réplication, d'un motif de réplication (704) comprenant une pluralité d'éléments de réplication (112a, 112b, 212a, 212b, 212c, 312a, 312b) présentant des hauteurs (114a, 114b) respectives différentes les uns des autres ; et
la réalisation d'une pluralité de processus de gravure sur le matériau de réplication, la structure multicouche et le substrat, afin d'obtenir un motif de substrat comprenant une pluralité d'éléments de substrat (706), chaque élément de substrat (134a, 134b, 224a, 224b, 224c, 314a, 314b, 602) respectif étant aligné avec une position d'un élément de réplication respectif des éléments de réplication, les éléments de substrat présentant des hauteurs (136a, 136b, 604a, 604b) respectives différentes les unes des autres, et un nombre de la pluralité de métacouches étant supérieur ou égal au nombre de hauteurs différentes pour les éléments de substrat formés par la pluralité de processus de gravure.

2. Procédé selon la revendication 1, dans lequel la pluralité d'éléments de réplication comporte un premier élément de réplication et un deuxième élément de réplication, et dans lequel une hauteur du premier élément de réplication est inférieure à une hauteur du deuxième élément de réplication, et dans lequel la pluralité de processus de gravure comprend un premier processus de gravure comprenant :
la gravure du matériau de réplication jusqu'à ce que le premier élément de réplication soit éliminé et qu'une portion du deuxième élément de réplication subsiste sur la structure multicouche.

3. Procédé selon la revendication 2, dans lequel la pluralité de processus de gravure comprend un deuxième processus de gravure, réalisé après le premier processus de gravure, le deuxième processus de gravure comprenant :
l'élimination par gravure d'une portion d'une couche de masque dur d'une première métacouche (110a), la portion éliminée par gravure de la couche de masque dur étant alignée avec la position du premier élément de réplication ; et
l'élimination par gravure d'une portion d'une couche d'espacement de la première métacouche, la portion éliminée par gravure de la couche d'espacement étant alignée avec la position du premier élément de réplication et avec une position de la portion éliminée par gravure de la couche de masque dur de la première métacouche.

4. Procédé selon la revendication 3, dans lequel le deuxième processus de gravure fait en sorte qu'une portion de la structure multicouche alignée avec la position du premier élément de réplication comporte moins de métacouches qu'une portion de la structure multicouche alignée avec la position du deuxième élément de réplication, et/ou dans lequel le deuxième processus de gravure fait en sorte qu'une portion de la structure multicouche alignée avec la position du premier élément de réplication soit plus mince qu'une portion de la structure multicouche alignée avec la position du deuxième élément de réplication.

5. Procédé selon la revendication 1, dans lequel une première partie de la pluralité de processus de gravure fait en sorte que la structure multicouche comporte une première portion et une deuxième portion, la première portion étant plus mince que la deuxième portion, et dans lequel une deuxième partie de la pluralité de processus de gravure comprend :
la gravure du substrat pour former un premier élément de substrat intermédiaire (130a, 130b, 218a, 218b, 218c) et un deuxième élément de substrat intermédiaire (130a, 130b, 218a, 218b, 218c), le premier élément de substrat intermédiaire est aligné avec la position de la première portion de la structure multicouche et le deuxième élément de substrat intermédiaire étant aligné avec la position de la deuxième portion de la structure multicouche.

6. Procédé selon la revendication 5, comprenant, à la suite de la gravure du substrat pour former les premier et deuxième éléments de substrat intermédiaires :
l'élimination par gravure de la première portion de la structure multicouche pour mettre à nu le premier élément de substrat intermédiaire et laisser en place au moins une partie de la deuxième portion de la structure multicouche ; et
l'élimination par gravure d'une portion du premier élément de substrat intermédiaire, la deuxième élément de substrat intermédiaire étant protégé de la gravure par la deuxième portion de la structure multicouche ; le procédé comprenant éventuellement, à la suite de l'élimination par gravure de la portion du premier élément de substrat intermédiaire
l'élimination par gravure d'au moins une partie de la deuxième portion de la structure multicouche, et
la gravure du substrat pour former le premier élément de substrat et le deuxième élément de substrat.

7. Procédé selon la revendication 1, comprenant, à la suite de l'impression du motif de réplication, l'élimination par gravure d'une couche résiduelle (116, 216) du matériau de réplication subsistant sur la surface de la structure multicouche.

8. Procédé selon la revendication 1, dans lequel le matériau de masque dur est un métal ou un oxyde métallique, éventuellement le matériau de masque dur comprenant du chrome.

9. Procédé selon la revendication 1, dans lequel le matériau d'espacement comprend au moins un des éléments suivants : un photorésist, un oxyde, ou un nitrure, et/ou dans lequel le matériau de réplication comprend au moins un des éléments suivants : un polymère, une résine époxy, ou une résine.

10. Procédé selon la revendication 1, dans lequel la pluralité de processus de gravure comprend :
une première gravure qui grave sélectivement le matériau de réplication par rapport au matériau de masque dur ;
une deuxième gravure qui grave sélectivement le matériau de masque dur par rapport au matériau d'espacement ; et
une troisième gravure qui grave sélectivement le matériau d'espacement par rapport au matériau de masque dur.

11. Procédé selon la revendication 1, dans lequel la pluralité de processus de gravure comprend une gravure qui grave sélectivement le substrat par rapport au matériau d'espacement.

12. Procédé selon la revendication 2, dans lequel la pluralité d'éléments de substrat comporte un premier élément de substrat et un deuxième élément de substrat, et dans lequel le premier élément de réplication jouxte le deuxième élément de réplication, et
dans lequel le premier élément de substrat jouxte le deuxième élément de substrat.

13. Procédé selon la revendication 1, dans lequel la pluralité d'éléments de substrat comporte un premier élément de substrat et un deuxième élément de substrat, et dans lequel le premier élément de substrat et le deuxième élément de substrat forment ensemble une partie ou la totalité d'une métastructure optique.

14. Procédé selon la revendication 1, dans lequel le substrat présente un indice de réfraction supérieur à 2,5 pour au moins une des lumières suivantes : ultraviolette, visible, ou infrarouge, et/ou dans lequel l'impression du motif de réplication comprend le durcissement du matériau de réplication.

15. Appareil comprenant :
un substrat (100, 200, 300) ; et
une structure multicouche (102, 202, 302) disposée sur le substrat, la structure multicouche comprenant une pluralité de métacouches (110a, 110b), chaque métacouche comprenant
une couche de masque dur (106a, 106b, 206a, 206b, 206c, 306) comprenant un métal ou un oxyde métallique, et
une couche d'espacement (108a, 108b, 208a, 208b, 208c, 308) sur laquelle est disposée la couche de masque dur, la couche d'espacement comprenant au moins un des éléments suivants : un photorésist, un oxyde, ou un nitrure,
le substrat comportant des éléments de substrat intermédiaires (130a, 130b, 218a, 218b, 218c) présentant des nombres respectifs différents de métacouches au-dessus des éléments de substrat intermédiaires.

16. Appareil selon la revendication 15, dans lequel chaque couche de masque dur présente une épaisseur comprise entre 10 nm et 50 nm, et/ou dans lequel chaque couche d'espacement présente une épaisseur comprise entre 5 nm et 50 nm, et/ou dans lequel chaque couche de masque dur comprend du chrome, et/ou dans lequel le substrat présente un indice de réfraction compris entre 3,5 et 5,0 pour au moins une des lumières suivantes : infrarouge, ultraviolette, ou visible et/ou dans lequel le substrat comprend une couche d'un premier matériau disposée sur une couche de substrat comprenant un deuxième matériau.
